# EUROPÄISCHE PATENTSCHRIFT

(11) **EP 3 077 328 B1**
(45) Veröffentlichungstag und Bekanntmachung des Hinweises auf die Patenterteilung: **01.08.2018**
(21) Anmeldenummer: 14825252.1
(22) Anmeldetag: 02.12.2014
(51) Int. Cl.: B82Y 10/00, H01L 41/09

(54) **VORRICHTUNG ZUR MECHANISCHEN SPANNUNGSBEAUFSCHLAGUNG EINER DÜNNSCHICHT**
DEVICE FOR MECHANICALLY APPLYING A VOLTAGE TO A THIN-FILM
DISPOSITIF D'APPLICATION D'UNE CONTRAINTE MÉCANIQUE À UNE COUCHE MINCE

(30) Priorität: 02.12.2013 AT 507892013
(43) Veröffentlichungstag der Anmeldung: 12.10.2016
(73) Patentinhaber: Universität Linz, 4040 Linz (AT)
(72) Erfinder: RASTELLI, Armando, 4020 Linz (AT); DARUKA, Istvan, 4040 Linz (AT); TROTTA, Rinaldo, 4040 Linz (AT)
(74) Vertreter: Patentanwaltskanzlei Hübscher
(86) Internationale Anmeldenummer: PCT/AT2014/050289
(87) Internationale Veröffentlichungsnummer: WO 2015/081361

(56) Entgegenhaltungen:
- US-A- 4 226 507
- US-A1- 2007 206 300
- BEETZ J ET AL: "Anisotropic strain-tuning of quantum dots inside a photonic crystal cavity", SEMICONDUCTOR SCIENCE AND TECHNOLOGY, IOP PUBLISHING LTD, GB, Bd. 28, Nr. 12, 20. November 2013 (2013-11-20), Seite 122002, XP020253830, ISSN: 0268-1242, DOI: 10.1088/0268-1242/28/12/122002 [gefunden am 2013-11-20]
- ZANDER T ET AL: "Epitaxial quantum dots in stretchable optical microcavities", OPTICS EXPRESS, OSA (OPTICAL SOCIETY OF AMERICA), WASHINGTON DC, (US), Bd. 17, Nr. 25, 1. Januar 2009 (2009-01-01), Seiten 22452-22461, XP002671163, ISSN: 1094-4087 [gefunden am 2009-11-23]

## Beschreibung

### Technisches Gebiet

Die Erfindung bezieht sich auf eine Vorrichtung zur mechanischen Spannungsbeaufschlagung einer Dünnschicht, die auf einem Substrat aufgebracht ist und einen Beaufschlagungsabschnitt aufweist, der von einem mit der Dünnschicht schubfest verbundenen, piezoelektrischen Aktuator umgeben ist.

### Stand der Technik

Der Einfluss elastischer Dehnungen auf die Materialeigenschaften wird beispielsweise in der Mikro-, Nano- und Optoelektronik zur Verbesserung der Leistung von Halbleitern genützt. Es können aber auch Dünnschichten für optische Zwecke durch bereichsweise elastische Dehnungen verformt werden, wobei vorteilhaft elektrisch steuerbare Aktuatoren eingesetzt werden. So ist es unter anderem zur Änderung der Brennweite eines optischen Systems bekannt (US 7 369 723 B1), eine kreisförmige Dünnschichtmembran, die entweder als Spiegelfläche genützt wird oder eine Begrenzung für ein einen Linsenkörper bildendes Flüssigkeitsvolumen darstellt, randseitig mit einem ringförmigen, piezoelektrischen Aktuator zu umgeben, der mit der Dünnschichtmembran schubfest verbunden ist, sodass bei einer Beaufschlagung des Aktuators mit einer elektrischen Spannung über eine innere und eine Äußere Ringelektrode auf die Dünnschichtmembran eine radiale Zugspannung aufgebracht werden kann, die bei einer vorgegebenen Ausgangskrümmung eine Vergrößerung des Krümmungsradius der Dünnschichtmembran und damit eine Verlängerung der Brennweite des auf einer solchen Dünnschichtmembran beruhenden optischen Systems bewirkt.

In ähnlicher Weise wird gemäß der US 2007/0206300 A1 die Krümmung einer zentralen Spiegelfläche mithilfe von Aktuatoren gesteuert, die durch die Spiegelfläche ringförmig umgebende Piezoelemente gebildet werden. Die zwischen den ringförmigen Elektroden wirksamen elektrischen Spannungen bedingen radiale Abstandsänderungen der sich zwischen den Elektroden ergebenden Piezoelemente mit der Folge, dass sich das die Spiegelfläche tragende, von den ringförmigen Piezoelementen umgebene Substrat entsprechend verformt, und zwar aufrgund der im Wesentlichen außerhalb der Spiegelfläche wirksamen Spannungen.

Um gezielt örtliche Bereiche einer Spiegel- oder Linsenfläche verformen zu können, ist es darüber hinaus bekannt (EP 1 191 377 B1), Piezoelemente in Form von Folien auf die zu verformende Flächenschicht aufzubringen, wobei zufolge des Musters der Anordnung, beispielsweise in einander paarweise gegenüberliegenden radialen Bahnen für rotationssymmetrische Verformungen optischer Elemente, die jeweils vorzunehmenden Verformungen berücksichtigt werden können. Durch die Verwendung einzelner Piezoelemente als Sensoren können die Verformungen überwacht werden, die sich durch die als Aktuatoren genützten Piezoelemente ergeben. Diese bekannten Anwendungen von piezoelektrischen Aktuatoren haben das Ziel, die geometrische Oberflächenform von Dünnschichten für optische Zwecke zu verändern und sind daher ungeeignet, Dünnschichten zur Beeinflussung ihrer physikalischen Eigenschaften mit einem durchstimmbaren Spannungstensor zu beaufschlagen.

Dies gilt auch für piezoelektrische Aktuatoren, die für eine Änderung der Form einer Membran quer zur Membranfläche sorgen, um die Wölbung eines von der Membran abgeschlossenen Flüssigkeitspolsters in einem zentralen Bereich durch eine randseitige Druckbeaufschlagung der Membran und die damit verbundene Flüssigkeitsverdrängung aus dem Randbereich in den zentralen Bereich (US 2010/0182703 A1) zu verändern oder die Dicke eines auf einer Seite durch eine Membran begrenzten Luftspalts durch eine Membranwölbung einzustellen (US 6 515 791 B1).

### Darstellung der Erfindung

Der Erfindung liegt somit die Aufgabe zugrunde, eine Vorrichtung zur mechanischen Spannungsbeaufschlagung einer Dünnschicht so auszubilden, dass sowohl in der Richtung als auch in der Größe vorgebbare Spannungszustände in der Dünnschicht erzeugt werden können.

Ausgehend von einer Vorrichtung der eingangs geschilderten Art löst die Erfindung die gestellte Aufgabe dadurch, dass der Aktuator einander paarweise bezüglich des Beaufschlagungsabschnitts gegenüberliegende, in ihrer Wirkrichtung radial zum Beaufschlagungsabschnitt verlaufende Piezoelemente umfasst und dass der Beaufschlagungsabschnitt der Dünnschicht über radiale Stege mit der übrigen Dünnschicht verbunden ist, die mit den Piezoelementen schubfest verbunden sind.

Aufgrund der einander paarweise bezüglich des Beaufschlagungsabschnitts der Dünnschicht gegenüberliegenden Piezoelemente können bei einer entsprechenden elektrischen Beaufschlagung der Piezoelemente auf den Beaufschlagungsabschnitt zwischen den einander gegenüberliegenden Piezoelementen Zugspannungen in wenigstens zwei durch die paarweise angeordneten Piezoelemente vorgegebenen Richtungen ausgeübt werden, und zwar unabhängig voneinander, weil ja an die Piezoelementpaare voneinander unabhängig elektrische Spannungen angelegt werden können. Die einander gegenüberliegenden Piezoelemente eines Paares sollen jedoch zur Wahrung symmetrischer Verhältnisse einem gleichen elektrischen Feld ausgesetzt werden, sodass die auf den Beaufschlagungsabschnitt aufgebrachten Zugspannungen zu keiner Verlagerung des Beaufschlagungsabschnitts führen können. Mit Hilfe der einander paarweise gegenüberliegenden, radial zum Beaufschlagungsabschnitt ausgerichteten Piezoelemente kann somit der Beaufschlagungsabschnitt der Dünnschicht in der durch die Wirkrichtung der paarweise angeordneten Piezoelemente vorgegebenen Richtung Zugspannungen ausgesetzt werden, deren Größe über die elektrische Spannung gesteuert werden kann, die an die Paare von Piezoelementen angelegt wird. Im Beaufschlagungsabschnitt der Dünnschicht können daher unterschiedliche Spannungszustände eingestellt werden, um entweder die Wirkung unterschiedlicher Spannungszustände auf die physikalischen Eigenschaften der Dünnschicht untersuchen zu können oder bestimmte, durch Spannungszustände beeinflussbare physikalische Eigenschaften einer Dünnschicht sicherzustellen.

Um den Einfluss der über die Piezoelemente nicht beaufschlagten Dünnschichtbereiche, die sich zwischen den in Umfangsrichtung benachbarten Piezoelementen im Anschluss an den Beaufschlagungsabschnitt erstrecken, auf den Spannungszustand des Beaufschlagungsabschnitts zu vermeiden, wird der Beaufschlagungsabschnitt der Dünnschicht über radiale Stege mit der übrigen Dünnschicht verbunden, die mit den Piezoelementen schubfest verbunden sind, sodass aufgrund des Fehlens dieser Dünnschichtbereiche die Spannungsbeaufschlagung des Beaufschlagungsabschnitts ausschließlich über die radialen Stege erfolgt, die in Ihrem Verlauf mit der Anordnung der einander paarweise gegenüberliegenden Piezoelemente übereinstimmt.

Besonders vorteilhafte Bedingungen hinsichtlich der Aufbringung mechanischer Spannungen auf den Beaufschlagungsabschnitt ergeben sich, wenn das Substrat die einander paarweise gegenüberliegenden Piezoelemente bildet, weil in diesem Fall die besseren piezoelektrischen Eigenschaften dickerer Piezoelemente in konstruktiv einfacher Weise genützt werden können. Es ist aber selbstverständlich auch möglich, die für manche Anwendungsfälle vorteilhaften Konstruktionsvoraussetzungen von Dünnschicht-Piezoelementen zu nützen, die allerdings ein gesondertes Substrat für die Halterung der mit einem Spannungstensor zu beaufschlagenden Dünnschicht benötigen.

Um innerhalb des durch den Beaufschlagungsabschnitt gegebenen Dünnschichtbereichs beliebige Spannungszustände erzeugen zu können, können drei jeweils um 60° gegeneinander versetzt angeordnete Paare von einander gegenüberliegenden Piezoelementen vorgesehen sein. Mit Hilfe der dadurch möglichen Spannungsbeaufschlagung in zueinander um 60 bzw. 120° geneigten Richtungen lassen sich die für eine bestimmte Einflussnahme auf die physikalischen Eigenschaften des Beaufschlagungsabschnitts erforderlichen Spannungstensoren in einfacher Weise verwirklichen.

### Kurze Beschreibung der Zeichnung

In der Zeichnung ist der Erfindungsgegenstand beispielsweise dargestellt. Es zeigen
- Fig. 1: eine nicht erfindungsgemäße Vorrichtung zur mechanischen Spannungsbeaufschlagung einer Dünnschicht in einer schematischen, zum Teil aufgerissenen Draufsicht,
- Fig. 2: diese Vorrichtung in einer zum Teil aufgerissenen Ansicht von unten,
- Fig. 3: einen Schnitt nach der Linie III-III der Fig. 1 in einem größeren Maßstab,
- Fig. 4: eine Ausführungsvariante einer erfindungsgemäßen Vorrichtung in einer schematischen, zum Teil aufgerissenen Draufsicht,
- Fig. 5: die Vorrichtung nach der Fig. 4 in einem Schnitt nach der Linie V-V der Fig. 4 in einem größeren Maßstab und
- Fig. 6: einen Schnitt nach der Linie VI-VI der Fig. 4 im Bereich eines Stegs der Dünnschicht in einem größeren Maßstab.

### Weg zur Ausführung der Erfindung

Erfindungsgemäße Vorrichtungen dienen beispielsweise als abstimmbare Quellen für verschränkte Photonen, wie sie für quantenoptische und quantenkommunikative Anwendungen in Betracht gezogen werden. Diese Vorrichtungen setzen nämlich eine Abstimmung der mechanischen Spannungen innerhalb der Quantenpunkte bildenden Halbleiterdünnschicht voraus. Die Erfindung ist aber selbstverständlich nicht auf eine solche Anwendung beschränkt, sondern kann überall dort angewendet werden, wo bestimmte Spannungstensoren innerhalb einer Dünnschicht eingestellt oder verändert werden müssen, wie dies beispielsweise in der Micro-, Nano- und Optoelektronik zur Verbesserung der Leistung von Halbleitern der Fall ist.

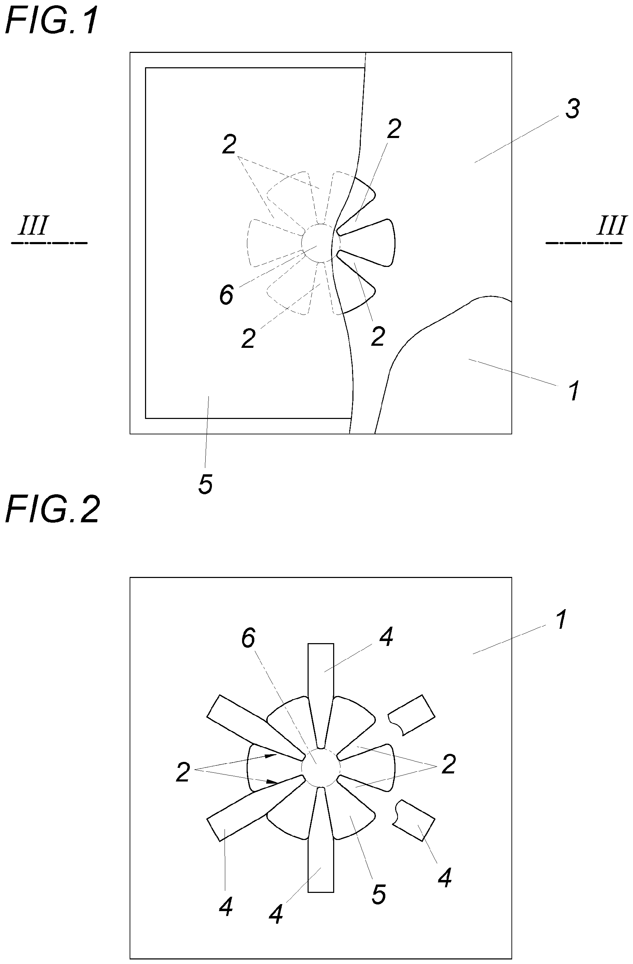

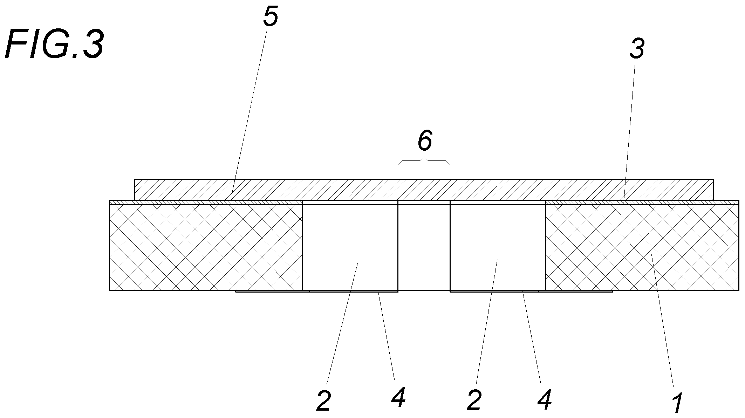

Die Vorrichtung gemäß dem nicht erfindungsgemäßen Beispiel nach den Fig. 1 bis 3 weist ein Substrat 1 auf, das einander paarweise gegenüberliegende Piezoelemente 2 bildet, die gegeneinander radial vorstehen. Diese Piezoelemente 2 sind auf ihrer Oberseite mit einer gemeinsamen, das Substrat 1 abdeckenden, an Masse gelegten Elektrode 3 und auf der gegenüberliegenden Unterseite mit auf die einzelnen Piezoelemente 2 beschränkten Elektroden 4 beschichtet, sodass die einzelnen Piezoelemente je für sich an eine elektrische Spannung angelegt werden können. Auf dem mit der Elektrode 3 abgedeckten Substrat 1 ist eine Dünnschicht 5, im Beispielsfall eine Halbleiterschicht in Form einer GaAs-Membran, aufgebracht, die einen mit Quantenpunkten versehenen Beaufschlagungsabschnitt 6 bildet, der sich zwischen den einzelnen Piezoelementen 2 ergibt und in den Fig. 1 und 2 strichpunktiert angedeutet ist.

Werden die schubfest mit der Dünnschicht 5 verbundenen Piezoelemente 2 über die Elektroden 3, 4 mit einer elektrischen Spannung beaufschlagt, die ein Zusammenziehen der Piezoelemente 2 in radialer Richtung bedingt, so wird der Beaufschlagungsabschnitt 6 zwischen den jeweils einander paarweise gegenüberliegenden Piezoelementen 2 mit in der Wirkungsrichtung dieser Piezoelemente 2 verlaufenden Zugspannungen belastet, die in ihrer Größe einstellbar sind und innerhalb des Beaufschlagungsabschnitts 6 für die Ausbildung bestimmter Spannungstensoren sorgen. Je nach der Beaufschlagung der einander paarweise gegenüberliegenden Piezoelemente 2 kann demnach der Beaufschlagungsabschnitt 6 der Dünnschicht 5 hinsichtlich des Spannungstensors durchgestimmt werden.

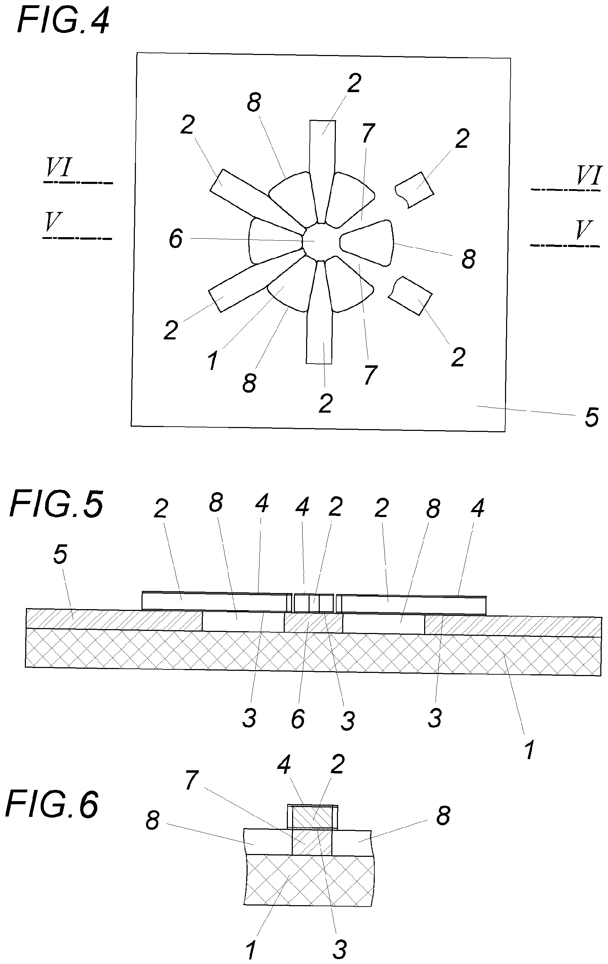

Zum Unterschied zu der nicht erfindungsgemäßen, beispielhaften Vorrichtung nach den Fig. 1 bis 3 werden gemäß dem Ausführungsbeispiel nach den Fig. 4 bis 6 die Piezoelemente 2 als Dünnschichtelemente ausgebildet, was das Vorsehen eines gesonderten Substrats 1 zur Aufnahme der Dünnschicht 5 erfordert. Das Substrat 1 kann beispielsweise auf der Basis von Galliumarsenid (GaAs), Silicium, Kupfer, Bleimagnesiumniobat-Bleititanat (PMN-PT) od. dgl. aufgebaut sein. Demzufolge sind die Piezoelemente 2 auf der dem Substrat 1 gegenüberliegenden Seite der Dünnschicht 5 anzuordnen, die entsprechend dem Ausführungsbeispiel nach den Fig. 1 bis 3 einander paarweise unter Freilassung eines Beaufschlagungsabschnitts 6 der Dünnschicht 5 angeordnet sind, sodass bei einem Anlegen einer elektrischen Spannung an die Piezoelemente 2 über die Elektroden 3, 4 der Beaufschlagungsabschnitt 6 der Dünnschicht 5 zwischen den Paaren von Piezoelementen 2 einem entsprechenden Spannungstensor unterworfen werden kann. Es braucht wohl nicht besonders hervorgehoben zu werden, dass hierfür die Dünnschicht 5 im Einflussbereich der Piezoelemente 2 gegenüber dem Substrat 1 gleitfähig gehalten werden muss.

Um auf den Beaufschlagungsabschnitt 6 besonders feinfühlig Zugspannungen über die Piezoelemente 2 aufbringen zu können, wird der Beaufschlagungsabschnitt 6 über radiale Stege 7 mit der übrigen Dünnschicht 5 verbunden, wobei die Dünnschicht 5 zwischen den Stegen 7 Aussparungen 8 aufweist. Diese Stege 7 stimmen in ihrem Verlauf mit der Anordnung der Piezoelemente 2 überein und sind mit diesen Piezoelementen 2 schubfest verbunden.

## Patentansprüche

1. Vorrichtung zur mechanischen Spannungsbeaufschlagung einer Dünnschicht (5), die auf einem Substrat (1) aufgebracht ist und einen Beaufschlagungsabschnitt (6) aufweist, der von einem mit der Dünnschicht (5) schubfest verbundenen piezoelektrischen Aktuator umgeben ist, **dadurch gekennzeichnet, dass** der Aktuator einander paarweise bezüglich des Beaufschlagungsabschnitts (6) gegenüberliegende, in ihrer Wirkrichtung radial zum Beaufschlagungsabschnitt (6) verlaufende Piezoelemente (2) umfasst und dass der Beaufschlagungsabschnitt (6) der Dünnschicht (5) über radiale Stege (7) mit der übrigen Dünnschicht (5) verbunden ist, die mit den Piezoelementen (2) schubfest verbunden sind.

2. Vorrichtung nach Anspruch 1, **dadurch gekennzeichnet, dass** das Substrat (1) die einander paarweise gegenüberliegenden Piezoelemente (2) bildet.

3. Vorrichtung nach Anspruch 1 oder 2, **dadurch gekennzeichnet, dass** drei jeweils um 60° gegeneinander versetzt angeordnete Paare von einander gegenüberliegenden Piezoelementen (2) vorgesehen sind.

## Claims

1. Device for mechanically applying a voltage to a thin film (5) which is attached to a substrate (1) and comprises an application portion (6) which is surrounded by a piezoelectric actuator connected to the thin film (5) in a shear-resistant manner, **characterised in that** the actuator comprises piezo elements (2) lying in pairs opposite one another with respect to the application portion (6) and extending in their operating direction radially with respect to the application portion (6), and that the application portion (6) of the thin film (5) is connected to the rest of the thin film (5) by radial webs (7) which are connected in a shear-resistant manner to the piezo elements (2).

2. Device as claimed in claim 1, **characterised in that** the substrate (1) forms the piezo elements (2) lying opposite one another in pairs.

3. Device as claimed in claim 1 or 2, **characterised in that** three pairs of mutually opposing piezo elements (2) are provided disposed offset by 60° with respect to one another in each case.

## Revendications

1. Dispositif d'application d'une contrainte mécanique à une couche mince (5), qui est déposée sur un substrat (1) et qui comporte une section d'application (6) qui est entourée d'un actionneur piézoélectrique relié à la couche mince (5) de manière solidaire au cisaillement, **caractérisé en ce que** l'actionneur comprend des éléments piézoélectriques (2), opposés les uns aux autres par paires par rapport à la section d'application (6), qui agissent dans une direction radiale par rapport à la section d'application (6) et **en ce que** la section d'application (6) de la couche mince (5) est reliée à la couche mince (5) restante par le biais de barrettes (7) radiales qui sont reliées, de manière solidaire au cisaillement, aux élément piézoélectriques (2).

2. Dispositif selon la revendication 1, **caractérisé en ce que** le substrat (1) forme les éléments piézoélectriques (2) opposés les uns aux autres par paires.

3. Dispositif selon la revendication 1 ou 2, **caractérisé en ce que** trois paires, respectivement disposées décalées les unes par rapport aux autres de 60°, d'éléments piézoélectriques (2) opposés les uns aux autres sont prévues.
